(19) Europäisches Patentamt / European Patent Office / Office européen des brevets

(11) **EP 2 769 466 B1**

(12) **EUROPEAN PATENT SPECIFICATION**

(45) Date of publication and mention
of the grant of the patent:
**05.08.2020 Bulletin 2020/32**

(21) Application number: **11796855.2**

(22) Date of filing: **21.11.2011**

(51) Int Cl.:
**H03B 5/18** $^{(2006.01)}$

(86) International application number:
**PCT/US2011/061674**

(87) International publication number:
**WO 2013/058784 (25.04.2013 Gazette 2013/17)**

(54) **VOLTAGE CONTROLLED OSCILLATORS HAVING LOW PHASE NOISE**

SPANNUNGSGESTEUERTE OSZILLATOREN MIT NIEDRIGEM PHASENRAUSCHEN

OSCILLATEURS COMMANDÉS EN TENSION À FAIBLE BRUIT DE PHASE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.10.2011 US 201113278052**

(43) Date of publication of application:
**27.08.2014 Bulletin 2014/35**

(73) Proprietor: **Qualcomm Incorporated
San Diego, CA 92121-1714 (US)**

(72) Inventor: **TERROVITIS, Emmanouil
Foster City, California 94404 (US)**

(74) Representative: **Best, Bastian
Bardehle Pagenberg Partnerschaft mbB
Patentanwälte, Rechtsanwälte
Prinzregentenplatz 7
81675 München (DE)**

(56) References cited:
**EP-A1- 1 505 720         EP-A1- 1 845 611
JP-A- 2009 088 673       US-A1- 2008 284 534
US-A1- 2011 128 084**

• **HOROWITZ M A ET AL: "A 10-GHz global clock
distribution using coupled standing-wave
oscillators", IEEE JOURNAL OF SOLID-STATE
CIRCUITS, IEEE SERVICE CENTER,
PISCATAWAY, NJ, USA, vol. 38, no. 11, 1
November 2003 (2003-11-01), pages 1813-1820,
XP011102768, ISSN: 0018-9200, DOI:
10.1109/JSSC.2003.818299**
• **XIAO H ET AL: "A 20 GHZ PUSH-PUSH
OSCILLATOR USING RING RESONATOR", IEICE
TRANSACTIONS ON ELECTRONICS, INSTITUTE
OF ELECTRONICS, TOKYO, JP, vol. E87-C, no.
12, 1 December 2004 (2004-12-01), pages
2143-2149, XP001212148, ISSN: 0916-8524**

**Description**

FIELD OF THE PRESENT INVENTION

The present disclosure generally relates to voltage controlled oscillators (VCOs) and more particularly to integrated inductor-capacitor tank VCOs (LC VCOs) having low phase noise.

BACKGROUND OF THE INVENTION

Voltage controlled oscillators (VCOs) are an important class of circuits widely used in modern electronic devices. For example, phase locked loops (PLLs) employing VCOs are used to isolate and demodulate signals and synthesize frequencies in wireless communication applications as well as provide critical timing functions in computing processors and data streams. As the name implies, the frequency output of a VCO may be tuned by varying the voltage applied to the circuit. A commonly used type of harmonic VCO utilizes a resonant circuit formed by inductors and capacitors and correspondingly is known as an LC VCO.

As integrated circuit (IC) manufacturing techniques have matured, a greater number of circuit elements have been implemented directly on the chip, avoiding the costs and complications associated with providing such elements as discrete items. These trends are exemplified by the development of system on a chip (SoC) and application specific IC (ASIC) technologies, in which multiple aspects of an electronic system, including analog, digital, mixed and RF functions, are integrated into a single chip. Given the importance of VCOs, there is a corresponding need to effectively incorporate such circuits into ICs using the semiconductor manufacturing processes. Accordingly, VCOs suitable for incorporation into an IC typically involve a substantially planar inductor coil formed from one or more metal layers in the IC. However, especially at higher frequencies, such as those associated with wireless communication, several challenges regarding the design of integrated VCOs exist.

In particular, phase noise is a frequency domain characteristic that corresponds to jitter in the time domain and can be considered an undesirable modulation of the VCO's oscillation frequency. Phase noise impacts many aspects of systems employing VCOs, including mixing performance, noise floor, noise transmission, interference and bit error rate depending on the type of system. Thus, phase noise is an important parameter of VCOs that must be minimized to obtain a desired level of performance. Thus, there is a need to provide VCO designs suitable for incorporation into ICs that have low phase noise. The systems of this disclosure satisfy these and other needs.

US 2008/284534 A1 discloses an oscillator that includes a plurality of excitation units for providing an excitation signal and a tank as an oscillation generating unit for generating an oscillation signal in response to the excitation signal.

Paper "A 10-GHz global clock distribution using coupled standing-wave oscillators" (Horowitz M. A. et al) discloses a global clock network that incorporates standing waves and coupled oscillators.

EP 1 505 720 A1 discloses an oscillator that comprises a three terminal device and first circuitry coupled across a first terminal and a second terminal of the three terminal device and operable to bias the three terminal device and to feedback a select amount of phase noise generated by the three terminal device into the three terminal device.

JP 2009 088673 A discloses an oscillator synchronizing a plurality of oscillation frequencies includes a plurality of oscillators; a ring resonator for coupling gates/bases of the plurality of oscillators with lines connected to respective ports of closed lines whose total length, comprising microstrip lines of one wavelength of an oscillation frequency; and an excitation direction fixing device for fixing an excitation phase inserted in the line of the ring resonator in one direction.

Paper "A 20 GHz Push-Push Oscillator Using Ring Resonator" (Xiao H. et al) discloses a 20 GHz push-push oscillator using a ring resonator.

SUMMARY OF THE INVENTION

The underlying problem of the present invention is solved by the independent claims. Preferred embodiments are provided by the dependent claims.

BRIEF DESCRIPTION OF THE DRAWINGS

Further features and advantages will become apparent from the following and more particular description of the preferred embodiments of the invention, as illustrated in the accompanying drawing, and in which like referenced characters generally refer to the same parts or elements throughout the views, and in which:

FIG. 1 is a schematic diagram of a LC VCO;

FIG. 2 is a schematic diagram of a pair of LC VCOs forming an oscillatory array;

FIG. 3 is a schematic diagram of an array of 16 LC VCOs.

DETAILED DESCRIPTION OF THE INVENTION

At the outset, it is to be understood that this disclosure is not limited to particularly exemplified materials, methods or structures as such may, of course, vary. Thus, although a number of materials and methods similar or equivalent to those described herein can be used in the practice of embodiments of this disclosure, the preferred materials and methods are described herein.

It is also to be understood that the terminology used herein is for the purpose of describing particular embodiments of this disclosure only and is not intended to be limiting.

Unless defined otherwise, all technical and scientific terms used herein have the same meaning as commonly understood by one having ordinary skill in the art to which the disclosure pertains.

Finally, as used in this specification and the appended claims, the singular forms "a, "an" and "the" include plural referents unless the content clearly dictates otherwise.

This disclosure is directed to integrated VCO configurations that feature low phase noise. LC VCOs are commonly used for RF applications because they have a lower phase noise than other inductor-less VCO topologies. Nevertheless, the performance of devices employing LC VCOs can still be improved by further minimizing their phase noise. As will be described in detail below, the inventive VCO arrays feature inductor designs suitable for implementation on-chip in ICs and result in oscillators having reduced phase noise.

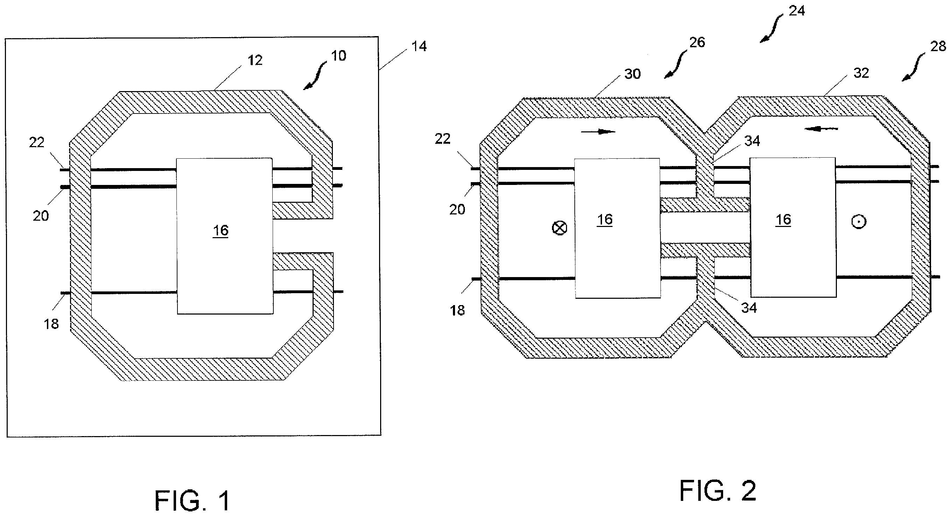

Turning to Fig. 1, a VCO 10 shown schematically and generally includes a single turn inductor coil 12 formed in an upper metal layer of an IC having a semiconductor substrate 14. Resonant circuit elements 16 are positioned within the area defined by coil 12. As will be appreciated, depending upon the design of the particular LC tank circuit used to drive VCO 10, circuit elements 16 can include transistors, capacitors, varactors and the like. Further, these circuit elements 16 are preferably formed using conventional semiconductor manufacturing techniques. Interconnects 18, 20 and 22 are preferably formed in metal layers below the coil 12 and provide suitable connections for supply lines, control signals and the like. If desired, interconnects 18-22 can also provide the necessary connections to the oscillator output.

As shown in Fig. 1, inductor coil 12 has a substantially square configuration with four primary sides and angled corners. Suitable shapes for the coil can include substantially circular, true square, rectangular or polygonal geometries as desired.

Phase noise for an LC VCO is often modeled using Leeson's equation. One formulation of this equation is:

$$(1) \qquad L_{PM} = 10 \log \left[ \frac{FkT}{A} \frac{1}{8Q_R^2} \left( \frac{f_0}{f_m} \right)^2 \right]$$

in which

$L_{PM}$ is single-sideband phase noise density
$F$ is the device noise factor at operating power level A
$k$ is Boltzmann's constant, $1.38 \times 10^{-23}$ J/K
$T$ is temperature
$A$ is oscillator output power
$Q_R$ is loaded Q
$f_o$ is the oscillator carrier frequency
$f_m$ is the frequency offset from the carrier.

In particular, $Q_R$ is the quality factor for the LC resonant circuit and depends upon the ratio of the energy stored to the energy dissipated in the circuit per oscillation cycle. From Equation (1), it is evident that phase noise is inversely related to $Q_R$. As such, phase noise can be minimized by selecting inductor designs that have a high quality factor, $Q_L$, for the inductor. As is known in the art, a single turn coil, such as coil 12, provides the highest quality factor for a given inductance value.

Although positioning circuit elements 16 within the area formed by coil 12 has the potential to degrade $Q_L$ due to electromagnetic interference such as eddy currents, careful design layout can minimize this impact. For example, one of skill in the art will recognize that forming loops with the interconnect inside the inductor should be avoided; otherwise the inductor flux will induce current in the loop and introduce loss. Regardless, the benefits that can be achieved using the design of VCO 10 described below can outweigh any degradation cost. Further, by placing circuit elements 16 within the area defined by coil 12, significant savings in the overall area of the IC can be achieved.

The resonant frequency of LC VCO 10 depends upon the product of the inductor and capacitor values according to the following equation:

$$(2) \qquad f_0 = \frac{1}{2\pi\sqrt{LC}}$$

As such, different values can be selected for the inductor and capacitor and still achieve the same frequency $f_0$. From equation (1), it can also be seen that by using a lower inductor value and a higher capacitance value to achieve a given frequency, an improvement in phase noise characteristics can be gained.

Accordingly, an oscillatory array 24 is formed by a complementary pair of VCOs 26 and 28 connected in parallel as depicted in Fig. 2. Each VCO 26 and 28 includes single turn inductor coils 30 and 32, respectively. Since the overall inductance of circuits in parallel is the reciprocal of the sum of the reciprocals of the individual inductances, connecting two VCOs 26 and 28 in parallel results in an overall inductance half that of each individual VCO (as VCOs 26 and 28 have the same L value). In turn, the parallel connection of capacitance is equal to the sum of the individual values, resulting in a doubling of the overall capacitance (again, as VCOs 26 and 28 have the same C value). By doubling the capacitance and halving the inductance, the resonant frequency $f_0$ is unchanged, but a reduction of 3 dB in phase noise is achieved.

As shown in Fig. 2, adjacent segments 34 of neighboring inductor coils 30 and 32 are preferably shared. This configuration also improves the $Q_L$ of each inductor of coils 30 and 32, resulting in an additional improvement in phase noise. Depending upon the geometries of the coils, different proportions of the shared segments can be achieved. In general, configurations in which the shared segments constitute a greater percentage result in a higher $Q_L$ and, correspondingly, better phase noise performance. In the example comprising two VCOs shown in Fig. 2, approximately 25 % of each coil 30 and 32 constitute shared segments 34. For a given VCO geometry, a greater percentage of the coil can be shared by employing multiple pairs as discussed below.

Further, as indicated in Fig. 2, the current flow in inductor coils 30 and 32 is in opposing directions, resulting in opposite flux polarity for coils 30 and 32. Due to their adjacency, each coil 30 and 32 can exploit a portion of the flux generated outside the area of the other coil that would otherwise be waster, which also increases the quality factor and reduces phase noise. Yet another benefit of this configuration is that any magnetic field interference that may be experienced by one coil is substantially cancelled since the same interference generates a phase error of the opposite polarity in the neighboring coil.

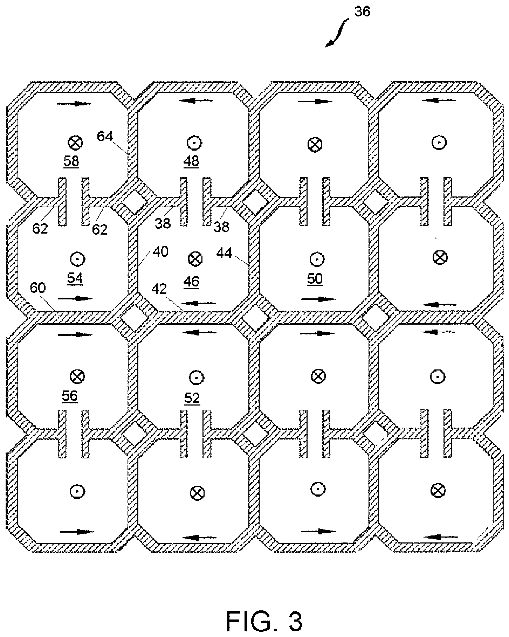

Additional improvements in phase noise can be achieved by increasing the number of VCOs connected in parallel so that multiple pairs of integrated VCOs are employed. In general, phase noise is reduced by 3 dB each time the number of VCOs is doubled. For example, Fig. 3 illustrates an array 36 of 16 VCOs in a symmetrical grid configuration. Since this represents four doublings of an individual VCO, the array 36 represents a phase noise reduction of 12 dB relative to the single VCO of Fig. 1.

Furthermore, the supplemental benefits discussed above are enhanced as the number of neighboring VCOs increase. Specifically, greater portions of each inductor coil can be shared with neighboring coils as there are neighbors on each side of the interior VCOs. For example, segments 38, 40, 42 and 44 of the inductor coil of VCO 46 are shared respectively by inductor coils of neighboring VCOs 48, 50, 52 and 54. As can be seen, the percentage of the coil that is shared for interior coils can be greater than 75% and can approach 100 %. VCOs located on the edges of array 36 do not benefit as greatly, but have an improved $Q_L$ as compared to a VCO that is not part of an array. Edge VCO 54 has three neighbors, VCOs 56, 46 and 58, and preferably shares coil segments 60, 40 and 62 as shown. Corner VCO 58 still receives the benefit of having two neighbors, VCOs 54 and 48, and can share coil segments 62 and 64.

As a result, the greater interactions yield an increased $Q_L$ for array 36 and additional improvements in phase noise characteristics. Other configurations can also be used as desired. In an embodiment employing an array of four VCOs for example, each VCO will have two neighbors and the shared segments of the coils can be in the range of approximately 50%.

Similarly, these configurations also lead to a more efficient use of the flux generated by the coils. For example, with respect to a first VCO 46 of array 36, it is surrounded by four VCOs 48, 50, 52 and 54 having opposite flux polarity due to the indicated current flow. As such, it can exploit the excess flux generated by each of its four neighbors. Further, the excess flux produced outside VCO 46 is efficiently used by the four neighbors. Again, the benefits are not as great for the VCOs that are not located in the interior of array 36, but improvements still result. As can be seen, every VCO in array 36 has at least two neighbors having opposing flux polarity in that the edge VCOs have two neighbors and the corner VCOs have three.

Described herein are presently preferred embodiments, however, one skilled in the art that pertains to the present invention will understand that the principles of this disclosure can be extended easily with appropriate modifications to other applications. For example, any number of suitable combinations of VCO pairs can be employed to achieve a desired level of phase noise. Further, different coil geometries can be used as desired to increase mutual interactions between the VCOs of the array to improve the overall quality factor and corresponding reduce phase noise.

**Claims**

1. An oscillatory array of two pairs of integrated VCOs, the VCOs of each pair of VCOs having opposing flux to each other, wherein:

   a. each VCO includes

      a1. resonant circuit elements (16) and
      a2. an inductor formed from a single turn coil (30, 32) positioned on a substantially planar substrate,

   b. wherein the resonant circuit elements (16) of each VCO (26, 28) are positioned within an area enclosed by the single turn coil (30, 32) of each VCO and substantially within the same plane, and
   c. wherein the VCOs (26, 28) in each pair of the VCOs are connected in parallel and positioned adjacent each other in the same plane, and
   d. wherein the single turn coil (30, 32) has a substantially square configuration with four primary sides and slanted corners, and in each pair of VCOs at least one segment (34) of the single turn coil inductor (30, 32) of each VCO (26, 28) is shared between the VCOs, and
   e. wherein the VCOs in the oscillatory array are arranged so that each VCO has exactly two neighboring VCOs having opposing flux polarities and shares segments of its single turn coil inductor with the two neighboring VCOs and the percentage of each single turn coil inductor that is shared is in the range of approximately 50%.

2. The oscillatory array of claim 1, wherein the substrate comprises a semiconductor.

**Patentansprüche**

1. Eine Oszillatoranordnung von zwei Paaren integrierter VCOs, wobei die VCOs jedes Paares von VCOs einen entgegengesetzten Fluss zueinander haben, wobei:

   a. jeder VCO enthält

      a1. Schwingkreiselemente (16) und
      a2. einen Induktor, der aus einer einzelnen Spule (30, 32) gebildet ist, die auf einem im wesentlichen ebenen Substrat angeordnet ist,

   b. wobei die Schwingkreiselemente (16) jedes VCOs (26, 28) innerhalb eines von der einzelnen Spule (30, 32) jedes VCOs umschlossenen Bereichs und im wesentlichen innerhalb derselben Ebene angeordnet sind, und
   c. wobei die VCOs (26, 28) in jedem Paar der VCOs parallel geschaltet und nebeneinander in derselben Ebene angeordnet sind, und
   d. wobei die Spule (30, 32) eine im Wesentlichen quadratische Konfiguration mit vier Primärseiten und schrägen Ecken aufweist und in jedem Paar von VCOs mindestens ein Segment (34) des Spuleninduktors (30, 32) jedes VCOs (26, 28) zwischen den VCOs geteilt wird, und
   e. wobei die VCOs in der Oszillatoranordnung so angeordnet sind, dass jeder VCO genau zwei benachbarte VCOs mit entgegengesetzten Flusspolaritäten hat und Segmente seines Spuleninduktors mit den beiden benachbarten VCOs teilt und der Prozentsatz jedes Spuleninduktors, der geteilt wird, im Bereich von etwa 50% liegt.

2. Oszillatoranordnung nach Anspruch 1, wobei das Substrat einen Halbleiter umfasst.

**Revendications**

1. Un réseau oscillatoire de deux paires d'oscillateurs commandés en tension, VCO, intégrés, les VCO de chaque paire de VCO ayant des flux opposés entre eux, dans lequel :

a. chaque VCO inclut

a1. des éléments de circuit résonant (16) et
a2. une inductance formée à partir d'une bobine à spire unique (30, 32) positionnée sur un substrat sensiblement plan,

b. dans lequel les éléments de circuit résonant (16) de chaque VCO (26, 28) sont positionnés à l'intérieur d'une zone entourée par la bobine à spire unique (30, 32) de chaque VCO et sensiblement à l'intérieur du même plan, et
c. dans lequel les VCO (26, 28) de chaque paire des VCO sont connectés en parallèle et positionnés de manière adjacente l'un à l'autre dans le même plan, et
d. dans lequel la bobine à spire unique (30, 32) possède une configuration sensiblement carrée avec quatre côtés principaux et des angles obliques, et dans chaque paire de VCO au moins un segment (34) de l'inductance à bobine à spire unique (30, 32) de chaque VCO (26, 28) est partagée entre les VCO, et
e. dans lequel les VCO du réseau oscillatoire sont agencés de sorte que chaque VCO possède exactement deux VCO voisins ayant des polarités de flux opposées et partage des segments de son inductance à bobine à spire unique avec les deux VCO voisins, et le pourcentage de chaque inductance à bobine à spire unique qui est partagée est dans la plage d'approximativement 50 %.

2. Le réseau oscillatoire selon la revendication 1, dans lequel le substrat comprend un semi-conducteur.

FIG. 1

FIG. 2

FIG. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2008284534 A1
- EP 1505720 A1
- JP 2009088673 A

**Non-patent literature cited in the description**

- **HOROWITZ M. A.** *A 10-GHz global clock distribution using coupled standing-wave oscillators*
- **XIAO H.** *A 20 GHz Push-Push Oscillator Using Ring Resonator*